# EUROPEAN PATENT APPLICATION

(11) **EP 4 765 646 A1**
(43) Date of publication of application: **24.06.2026**
(21) Application number: 24222391.5
(22) Date of filing: 20.12.2024
(51) Int. Cl.: H03K 19/0175, H01L 25/065

(54) **A 3D IC AND A METHOD FOR FORMING A 3D IC**

(71) Applicant: Imec VZW, 3001 Leuven (BE)
(72) Inventor: ZOGRAFOS, Odysseas, 3010 Kessel-Lo (BE); MYERS, James Edward, Great Wibraham, CB21 5JD (GB); RYCKAERT, Julien, 3080 Tervuren (BE); HELLINGS, Geert, 1500 Halle (BE)
(74) Representative: Lind Edlund Kenamets Intellectual Property AB

(57) **Abstract**

In an aspect there is provided a 3D IC, comprising:
a stack of device tiers comprising a first and a second device tier;
a data processing circuit comprising a set of launch and capture circuits, and a set of processing stages,
wherein each processing circuit is connected between a launch circuit and a capture circuit,
wherein the data processing circuit is partitioned between the first and second device tiers such that the set of launch and capture circuits is arranged in the first device tier and the set of processing stages is arranged in the second device tier.

## Description

### TECHNICAL FIELD

The present disclosure generally relates to a 3D integrated circuit (IC) and further to a method for forming a 3D IC.

### BACKGROUND

There is a constant strive in the semiconductor industry to scale down the device dimensions to realize circuits with higher density and performance. Scaling by feature size reduction is becoming increasingly challenging and costly. Therefore, there is increasing interest in design and integration technologies for 3D integrated circuits (3D IC) comprising a plurality of device tiers stacked on top of each other. For instance, a system-on-chip (SOC) realized as a 3D IC may comprise a number of stacked device tiers implementing logic circuitry.

While logic-on-logic stacking may facilitate improved area efficiency it introduces new challenges. Among others, logic paths are typically heterogeneous in the sense that they include combinations of sequential and combinational logic. Hence, logic-on-logic stacking may require back-end-of-line (BEOL) interconnect structures with a number of layers and complexity, as well as fine pitch inter-tier interconnection patterns for signal routing between the stacked logic tiers.

### SUMMARY

It is an object of the present disclosure to provide new design and fabrication approaches for 3D ICs, facilitating logic-on-logic stacking. More specifically, it is an object to address or alleviate at least some of the above-mentioned challenges associated with logic-on-logic stacking. Further and alternative objects may be appreciated from the following.

According to a first aspect of the present disclosure, there is provided a 3D IC comprising:
a stack of device tiers comprising a first and a second device tier;
a data processing circuit comprising a set of launch and capture circuits, and a set of processing stages,
wherein each processing circuit is connected between a launch circuit and a capture circuit,
wherein the data processing circuit is partitioned between the first and second device tiers such that the set of launch and capture circuits is arranged in the first device tier and the set of processing stages is arranged in the second device tier.

The 3D IC of the first aspect is at least in part based on the insight that partitioning (i.e., splitting / dividing) launch and capture circuits, and the intermediate processing stages of a data processing circuit between two respective device tiers, enables technology optimizations, both for the front-end-of-line (FEOL) and BEOL, tailored to the respective types of logic circuitry. For instance, for the processing stages (which typically is dominated by combinational logic) the design and fabrication tend to focus on circuit density, whereas for the launch and capture circuits (e.g., flip-flops or latches) the focus is on stability and reliability. These different technology requirements may in turn result in different design constraints for the active devices (transistors) of the respective circuit types.

Additionally, the outputs and inputs of launch and capture circuits, respectively, are typically connected to an input and output, respectively, of a combinational logic cell (directly, or via an intermediate buffer). Therefore, the partitioning approach of the present disclosure enables a direct 3D inter-tier connectivity pattern which may alleviate inter-tier routing congestion significantly. More specifically, the granularity (i.e., pitch) of the inter-tier connections may be defined by the unit area of the launch and capture circuits, as (at most) every launch and capture circuit (i.e., circuit cell) typically only needs to have direct access to an interconnection "upwards" to the second device tier.

In the present disclosure, the term "device tier" refers to a layer or level of a 3D IC comprising a respective active device layer. For instance, the first/second device tier may be a first/second chip of a stack of chips, each chip comprising a respective active device layer. The active device layer of a given device tier comprises the active devices of the device tier. The first/second device tier may further comprise a first/second frontside interconnect structure arranged on a frontside of the first/second chip of active device layer. The first/second device tier may further comprise a first/second backside interconnect structure arranged on a respective backside of the first/second chip of active device layer.

In the present disclosure, the term "launch circuit" refers to a circuit (e.g., a register such as a flip flop or latch) configured to supply data to an associated processing segment of the data processing circuit, while the term "capture circuit" refers to a circuit (e.g., a register such as a flip flop or latch) configured to receive and store processed data from an associated processing segment of the data processing circuit, e.g., to be output to a successive processing segment (by a successive launch circuit). The term "processing segment" refers to a circuit implementing at least combinational logic. While the first device tier comprises launch and capture circuits (i.e., sequential logic), this does not preclude presence of some combinational logic gates or cells (e.g., relatively basic / small combinational logic gates or cells such as ANDs, NANDs, buffers or inverters), e.g., for supporting the launch and capture circuits. Correspondingly, while the second device tier may be dominated by combinational logic, this does not preclude presence of some sequential logic gates or cells (e.g., relatively basic / small sequential logic gates or cells). However, in accordance with the present disclosure, within the volume occupied (i.e., spanned) by the data processing circuit, the second device tier is absent of launch and capture circuits. In some embodiments, each processing stage of the second device tier may be dedicated combinational stages, i.e., implemented exclusively by combinational logic.

In some embodiments, each processing circuit is connected to its associated launch and capture circuits by a set of inter-tier interconnects.

In some embodiments, each processing stage comprises at least one output combinational logic cell configured to supply output data to its associated capture circuit, and at least one input combinational logic cell configured to receive input data from its associated launch circuit.

The processing stages may thus be sequentially connected or cascaded with the launch and capture circuits.

In some embodiments, each processing stage further comprises at least one intermediate logic cell connected between the at least one input and output combinational logic cells.

In some embodiments, each launch or capture circuit is a latch or a flip flop

The launch and capture circuits may thus be realized using both edge-triggered (flip-flops) and level-triggered (latches) registers.

In some embodiments, the method further comprises a clock distribution network connected to a set of clock inputs of the launch and capture circuits, wherein the clock distribution network at least in part is comprised in the first device tier.

One or more of the launch and capture circuits may thus be realized using synchronous logic. This may facilitate the circuit design and distribution of data across the data processing circuit.

In some embodiments, one or more of the launch and capture circuits may be realized by clocked flip-flops.

In some embodiments, the clock distribution network may at least in part be comprised in the first device tier.

Allocating the launch and capture circuits to the first device tier allows a lower proportion of the synchronous / clocked (sequential) logic of the data processing circuit to be allocated to the processing segments of the second device tier. In some embodiments, the processing segments may even be void of synchronous logic and, for instance, comprise only asynchronous and combinational logic, or only combinational logic. Thus, in either case, by a greater proportion of the clocked logic being allocated to the first device tier, allocating also the clock distribution network, at least in part, to the first device tier may further allow congestion due to routing of clock signals between the device tiers to be avoided, as well as congestion in any back-end-of-line (BEOL) interconnect structure of the second device tier, within the footprint of the data processing circuit.

Moreover, the clock distribution network may be realized using capacitive clock signal routing interconnects of shorter total length, thus enabling a clock distribution network with overall lower resistance and capacitance, and hence by extension improved power and energy efficiency.

In some embodiments, the first device tier comprises a first active device layer and a first interconnect structure arranged at a side of the first active device layer facing away from the second device tier, and wherein the clock distribution network is comprised in first active device layer and the first interconnect structure.

Providing the clock distribution network in the first interconnect structure of the first device tier facing away from the second device tier may reduce competition for routing resources in any interconnect structure between the device tiers, such that more routing resources remain available for routing non-clock signals, as well as for routing signals between the first and second device tiers.

Further, by routing the clock distribution network at the side of the first active device layer facing away from the second device tier, an amount of noise introduced by the clock signals in the second device tier may be limited.

In some embodiments, the side of the first active device layer facing away from the second device tier is a backside of the first active device layer, and the first interconnect structure is a first backside interconnect structure arranged at the backside of the first active device layer. The first active device layer may further comprise a frontside facing the second device tier. The first device tier may further comprise a first frontside interconnect structure arranged at the frontside of the first active device layer. The first frontside interconnect structure may be bonded to a second backside interconnect structure of the second device tier.

In some embodiments, the side of the first active device layer facing away from the second device tier is a frontside of the first active device layer, and the first interconnect structure is a first frontside interconnect structure arranged at the frontside of the first active device layer. The first active device layer may further comprise a backside facing the second device tier. The first device tier may further comprise a first backside interconnect structure arranged at the backside of the first active device layer. The first backside interconnect structure may be bonded to a second backside interconnect structure of the second device tier.

In some embodiments, the first interconnect structure further comprises a power distribution network connected to the data processing circuit in the first and second device tiers

The data processing circuit may thus be powered by a common power distribution network (PDN). Providing the PDN at least in part in the first interconnect structure of the first device tier facing away from the second device tier may reduce competition for routing resources in any interconnect structure between the device tiers, such that more routing resources remain available for routing non-power signals (e.g., data signals), as well as for routing non-power signals between the first and second device tiers.

In some embodiments, the second device tier comprises a second active device layer, a second frontside interconnect structure and a second backside interconnect structure arranged at a frontside and a backside, respectively, of the second active device layer, wherein the second frontside interconnect structure is configured to interconnect active devices of the set of processing stages, and wherein the backside of the second active device layer tier faces the first device tier.

Thus, the second device tiers may be stacked with its backside facing the first device tier. The second frontside interconnect structure of the second device tier (which typically will implement most of the signal routing between active devices of the processing segments of the data processing circuit) may thus be distanced from the clock distribution network, and further not contribute to routing congestion between the first and second device tiers.

In some embodiments, where the first interconnect structure comprises a PDN, the power distribution network of the first interconnect structure is connected to a local power distribution network of the second device tier comprised at least in part in the second backside interconnect structure, and optionally also in the second frontside interconnect structure

Hence, a local PDN (potentially smaller and/or less dense) may be used to distribute power to the processing stages of the second device tier.

In some embodiments, the data processing circuit has a first footprint in the first device tier, and a second footprint in the second device tier overlapping the first footprint, and wherein, within the second footprint, the second device tier is clock-less

According to a second aspect of the present disclosure, there is provided a method for forming a 3D integrated circuit, IC,
the 3D IC comprising:
a stack of device tiers comprising a first and a second device tier;
a data processing circuit comprising a set of launch circuits and capture circuits, and a set of processing stages,
wherein each processing stage is connected between a launch circuit and a capture circuit,
wherein the data processing circuit is partitioned between the first and second device tiers such that the set of launch and capture circuits is arranged in the first device tier and the set of processing stages is arranged in the second device tier, and
the method comprising:
   forming the first device tier on a first wafer and the second device tier on a second wafer; and
   forming a wafer stack of the first and second wafers.

Hence a 3D IC, with the effects and merits discussed in the above, may be formed by stacking separately processed wafers, wherein the first wafer comprises the launch and capture circuits and the second wafer comprises the processing stages of the data processing stages.

In some embodiments,
the first and second wafers each have a frontside and a backside,
wherein forming the first device tier comprises forming active devices of the launch and capture circuits on the frontside of the first wafer and a first frontside interconnect structure on the frontside of the first wafer;
wherein forming the second device tier comprises forming active devices of the processing stages on the frontside of the second wafer and a second frontside interconnect structure on the frontside of the second wafer;
wherein the first and second wafers are bonded with the first frontside interconnect structure facing the backside of the second wafer.

In some embodiments, forming the first device tier further comprises forming a first backside interconnect structure on the backside of the first wafer.

In some embodiments, the first backside interconnect structure comprises a clock distribution network and/or a power distribution network.

In some embodiments, the method further comprises thinning the first wafer after bonding the first wafer and second wafers and thereafter forming the first backside interconnect structure on the backside of the thinned first wafer

In some embodiments, forming the second device tier further comprises forming a second backside interconnect structure on the backside of the second wafer, and wherein bonding the first and second wafers comprises bonding the first frontside interconnect structure to the second backside interconnect structure.

In some embodiments, the first and second wafers each have a frontside and a backside,
wherein forming the first device tier comprises forming active devices of the launch and capture circuits on the frontside of the first wafer and a first frontside interconnect structure on the frontside of the first wafer;
wherein forming the second device tier comprises forming active devices of the processing stages on the frontside of the second wafer and a second frontside interconnect structure on the frontside of the second wafer;
wherein the first and second wafers are bonded with the backside of the first wafer facing the backside of the second wafer.

### BRIEF DESCRIPTION OF THE DRAWINGS

The above, as well as additional objects, embodiments, features and effects of the present disclosure, may be better understood through the following illustrative and non-limiting detailed description, with reference to the appended drawings. In the drawings like reference numerals will be used for like elements unless stated otherwise.
Fig. 1 schematically shows a cross-section of a 3D IC device in accordance with some embodiments.
Fig. 2 is a schematic block diagram of a data processing circuit of the 3D IC device of Fig. 1, partitioned between first and second device tiers in accordance with some embodiments.
Fig. 3 schematically shows a cross-section of an example implementation of the 3D IC device of Fig. 1 in accordance with some embodiments.
Fig. 4 schematically shows a cross-section of a further 3D IC device in accordance with some embodiments.
Fig. 5-6 schematically show various embodiments of 3D ICs comprising a data processing circuit partitioned between first and second device tiers.
Fig. 7 schematically shows a first method for forming a 3D device in accordance with some embodiments.
Fig. 8 schematically shows a second method for forming a 3D device in accordance with some embodiments.

### DETAILED DESCRIPTION

Example embodiments of a 3D integrated circuit (IC) or 3D IC device will in the below be described with reference to the drawings. The drawings are only schematic and the relative dimensions of some structures and layers may be exaggerated and not drawn to scale. Rather the dimensions may be adapted for illustrational clarity and to facilitate understanding. When present in the figures, the indicated axes X and Y consistently refer to a horizontal direction and a vertical direction, respectively. As used herein, the term "horizontal" refers to a direction parallel to a main plane of extension of a device tier, a die or substrate of the 3D IC. The term "vertical" refers to a direction parallel to a normal direction to the main plane of extension of a device tier, die or substrate, i.e., transverse to the horizontal direction. In other words, "horizontal" and "vertical" refer respectively to in-plane and out-of-plane directions with respect to a device tier, die or substrate. In the present disclosure, when an element (e.g. a die or other structure) is referred to as being "on" another element, it can be directly on the other element or on one or more intermediate elements on the other element. Conversely, when an element is referred to as being "directly on" another element, there is no intermediate element and the element is thus formed in physical contact or abutment with the other element. In the present disclosure, when two elements are said to be "connected" or "interconnected" it is meant that the elements are electrically connected or coupled, directly or via one or more intermediate conductive structures (e.g., interconnects), unless stated otherwise.

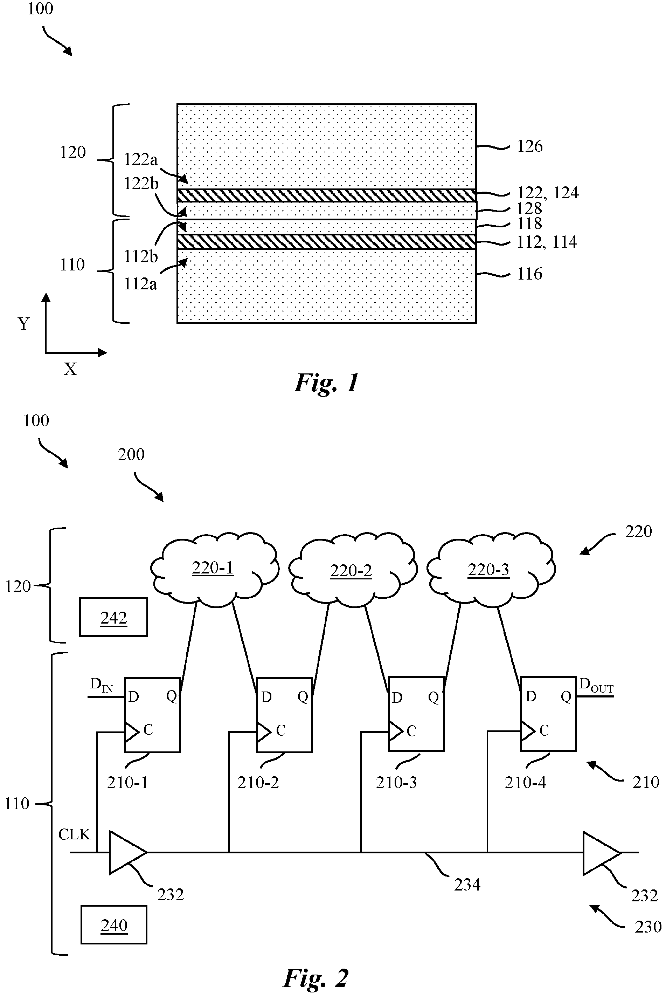

Fig. 1 shows a schematic cross-section of a 3D IC device 100 in accordance with some embodiments of the present disclosure. The IC device 100 comprises a stack of device tiers including a first device tier 110 and a second device tier 120. The second device tier 120 is stacked on top of, i.e., arranged above, the first device tier 110, as seen along the Y direction. While Fig. 1 shows two device tiers 110, 120, the first and second device tiers 110, 120 may more generally be two device tiers of a plurality of stacked circuit tiers. As further described in the following, the first and second device tiers 110, 120 may in some implementations correspond to first and second dies, respectively, of a stack of dies.

The first device tier 110 comprises a first active device layer 112. The second device tier 120 comprises a second active device tier 122. The first active device layer 112 comprises a first set of active devices 114 (i.e., transistors). The second active device layer 122 comprises a second set of active devices 124 (i.e., transistors). The first active device layer 112 is in Fig. 1 schematically depicted as a single layer. However, the first active device layer 112 may comprise a substrate and a front-end-of-line (FEOL) structure arranged or formed on the substrate and comprising the first set of active devices 114. The first set of active devices 114 may thus be referred to as frontend transistors of the active device layer and/or FEOL structure. The second active device layer 122 may have a corresponding structure, and thus comprise a substrate and a FEOL structure arranged or formed on the substrate and comprising the second set of active devices 124. The second set of active devices 124 may thus be referred to as frontend transistors of the FEOL structure. The substrates of the first and second active device layers 112, 122 may each be a conventional semiconductor substrate, suitable for CMOS devices and semiconductor device processing, for instance a semiconductor substrate of Si, Ge or SiGe. Other non-limiting examples include a silicon-on-insulator (SOI) substrate, a GeOI substrate or a SiGeOI substrate. By the term "FEOL structure" is herein meant a layer, tier or vertical section of an IC device comprising an active semiconductor layer (i.e., comprising the active regions or patterns of the active devices / transistors) and a gate layer (i.e., comprising the gates of the active devices). The active regions may comprise S/D regions and channel regions of the active devices. The FEOL structure may further comprise a local contact or interconnect layer (i.e., comprising the source/drain (S/D) contacts of the active devices). While referred to as a single layer, the local contact layer may typically comprise (at least) two metal layers: a bottom layer ("contact-to-active" or "trench silicide") and a top or "plug" layer (e.g. of TiN, Co, Ru and/or W). The active devices of the FEOL structure may comprise NMOSFETs and PMOSFETs, for instance realized as horizontal channel FETs, such as FinFETs, nanosheet FETs or nanowire FETs. The active semiconductor layer may be formed by semiconductors such as Si, Ge or SiGe, or other bulk / 3D semiconductors conventionally used to realize CMOS devices. The active semiconductor layer may be formed on a substrate of the respective active device layer and/ or in a thickness portion of the substrate. As per se is known the art, it is possible to perform substrate or wafer thinning during device fabrication, to provide access to the active devices (e.g., source/drain contacts) from a backside. Thus, during device fabrication, a respective substrate of the first and/or second device tier 110, 120 may be thinned. In case of extreme substrate thinning, the substrate(s) may be substantially removed such that only the FEOL structure remains in the finished IC device 100. Thus, a substrate may in some implementations be regarded as an optional feature of an active device layer.

The first device tier 110 further comprises a first interconnect structure 116, e.g., a back-end-of-line (BEOL) interconnect structure. By the term "BEOL interconnect structure" (or simply "interconnect structure") is herein meant a structure of one or more interconnect layers, each comprising interconnects, (typically of metal) such as horizontally routed interconnects (conductive traces or lines) or vertically routed interconnects ("vias"), embedded in interlayer dielectrics. An interconnect layer of horizontally routed interconnects may be referred to as a "metal routing layer" (or simply "routing layer"). An interconnect layer of vertically routed interconnects may be referred to as a via layer. A via layer may thus provide vertical routing of signals between different metal routing layers, or between a routing layer and conductive elements of the FEOL structure (e.g., gates or S/D contacts).

In the illustrated example, the first interconnect structure 116 is arranged at a frontside 112a of the first active device layer 112, i.e., on top of the FEOL structure of the first active device layer 112. The first interconnect structure 116 of the first device tier 110 may hence be designated as a first frontside interconnect structure 116. The first frontside interconnect structure 116 may, among others, be configured to interconnect the first set of active devices 114 of the first active device layer 112.

The second device tier 120 further comprises a second (BEOL) interconnect structure 126. The second interconnect structure 126 is in the illustrated example arranged at a frontside 122a of the second active device layer 122, i.e., on top of the FEOL structure of the second active device layer 122. The second interconnect structure 126 of the second device tier 120 may hence be designated as a second frontside interconnect structure 126. The second frontside interconnect structure 112 may, among others, be configured to interconnect the second set of active devices 124 of the second active device layer 122.

The first and the second device tiers 110, 120 are in the illustrated example stacked such that the respective backsides 112b, 122b of the first and second active device layers 112, 122 are facing each other, i.e., back-to-back. More specifically, the first device tier 110 may as shown comprise a further first interconnect structure 118 arranged at a backside 112b of the first active device layer 112. The second device tier 120 may correspondingly comprise a further second interconnect structure 128 arranged at a backside 122b of the second active device layer 122b. The further first interconnect structure 118 of the first device tier 110 may thus be referred to as first backside interconnect structure 118 of the first device tier 110. The further second interconnect structure 128 of the second device tier 120 may be referred to as second backside interconnect structure 128 of the second device tier 120. The first and second device tiers 110, 120 are here bonded to each other via the backside interconnect structures 118, 128. The backside interconnect structures 118, 128 thus form a bonding interface between the first and second device tiers 110, 120. Each of the backside interconnect structures 118, 128 may comprise one or more interconnect layers, for instance one or more via layers and one or more routing layers, and be connected to the active devices 114, 124 of the respective active device layers 112, 122 by backside contacts and/or TSVs. In the present disclosure, the term "TSV" refers to a via structure (i.e., a vertical electrical interconnect) extending through a substrate and/or FEOL structure, regardless of the type of semiconductor material of the active layer, consistent with its typical usage in the semiconductor industry. The inter-tier connections between the first and second device tiers 110, 120 may for example be implemented by hybrid bond pads, i.e., bonded pads of the first and second dies. More generally, the specific implementation of the inter-tier connections may depend on the device technology used to realize the IC device 100.

As may be appreciated from the above, in some implementations, the illustrated partitioning of the IC device 100 into the first and second device tiers 110, 120 may correspond to an actual structural and/or manufacturing-related partitioning of the IC device 100. For example, the IC device 100 may comprise a stack of dies, wherein the first and second device tiers 110, 120 may correspond respectively to a first and a second die. In the present disclosure, the term "die" is used to refer to a die structure or chip of an IC device. Thus, the first active device layer 112 (e.g., comprising a FEOL structure and optionally a substrate) may be an active device layer of the first die, the first interconnect structure 116 may be a frontside interconnect structure of the first die, and the further first interconnect structure 118 may be a backside interconnect structure of the first die. Correspondingly, the second active device layer 122 (e.g., comprising a FEOL structure and optionally a substrate) may be an active device layer of the second die, the second interconnect structure 126 may be a frontside interconnect structure of the second die, and the further second interconnect structure 128 may be a backside interconnect structure of the second die. The first and second device tiers/dies 110, 120 may be fabricated and subsequently be stacked and bonded with the backside interconnect structures 118, 128 facing each other. Thus, while the second interconnect structure 126 in this example is fabricated at a frontside of the second die, it may after stacking and bonding define a backside interconnect structure 126, with respect to the first die. Methods for forming an IC device such as the IC device 100 are described in further detail below.

In accordance with the present disclosure, the IC device 100 comprises a data processing circuit. Fig. 2 is a block diagram showing in a schematic manner a circuit configuration of an example implementation of a data processing circuit 200 of the 3D IC device 100. The data processing circuit 200 may in particular be implemented as a pipelined data processing circuit 200.

The data processing circuit 200 comprises a set of launch and capture circuits 210-1, 210-2, 210-3, 210-4, and a set of processing stages 220-1, 220-2, 220-3. Reference sign 210 may in the following be used to refer to any one of the launch and capture circuits 210-1, 210-2, 210-3, 210-4. Correspondingly, reference sign 220 may be used to refer to any one of the processing stages (hereinafter termed processing circuits) 220-1, 220-2, 220-3. The data processing circuit 200 is further partitioned (i.e., distributed) between the first and second device tiers 110, 120 such that the launch and capture circuits 210 are arranged in the first device tier 110 and the set of processing circuits 220 are arranged in the second device tier 120. Fig. 2 shows by way of example four launch and capture circuits 210-1, 210-2, 210-3, 210-4 and three processing stages 220-1, 220-2, 220-3. It is to be noted that the depicted number of launch and capture circuits 210 and processing stages 220 merely is an example, and that the data processing circuit 200 typically may comprise a greater number of such circuits 210 and stages 220.

Each processing circuit 220 is connected between a respective pair of launch and capture circuits 210. For example, the processing circuit 220-1 is connected between the launch and capture circuits 210-1 and 210-2, and the processing circuit 220-2 is connected between the launch and capture circuits 210-2 and 210-3. Each launch and capture circuit 210 may comprise respective capture circuit and a respective launch circuit connected in sequence with the capture circuit, to the output of the capture circuit. Thus, each processing circuit 220 is connected between a launch and capture circuit. The launch and capture circuits 210 are here by way of example implemented by D flip-flops having a data input D, a data output Q and a clock input C.

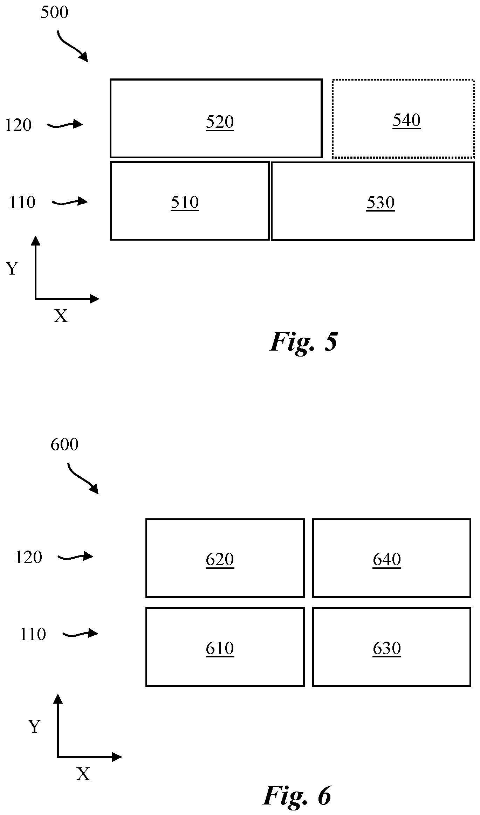

The launch and capture circuit 210-1 represents the first launch and capture circuit in the sequence of launch and capture circuits 210 of the data processing circuit 200. The data input D of the first launch and capture circuit 210-1 is thus configured to receive input data D_{IN} to be processed by the data processing circuit 200. Correspondingly, the launch and capture circuit 210-4 represents the last launch and capture circuit in the sequence of launch and capture circuits 210 of the data processing circuit 200. The data input D of the last launch and capture circuit 210-4 is thus configured to capture the input data D_{IN} after being processed by each of the processing circuits 220. The input data D_{IN} may be received/captured from, and the output data D_{OUT} may be output/launched to, surrounding circuitry of the IC device 100, examples of which are discussed below with reference to Fig. 5-7.

The processing stages/circuits 220 are schematically depicted but may typically comprise an output combinational logic cell configured to supply output data to its associated capture circuit 210, and at least one input combinational logic cell configured to receive input data from its associated launch circuit 210. Each processing stage 220 may further comprise at least one intermediate logic cell connected between the at least one input and output combinational logic cells. Each intermediate logic cell may be combinational logic cell or a sequential logic cell. In some implementations, each of the processing circuits 220 of the data processing circuit 200 may be a dedicated combinational circuit, i.e., implemented exclusively by combinational logic, and thus define a non-clocked / clock-less portion of the data processing circuit 200 in the second device tier 120. Thus, the second device tier 120 may be realized as a clock-less device tier, at least within the footprint of the second device tier 120 overlapping the footprint of the first device tier 110. However, as will become apparent from the further description (see e.g., Fig. 200), in some implementations there may be sequential logic (synchronous or asynchronous) in portions of the second device tier 120 located outside the footprint of the first device tier 110.

The launch and capture circuits 210 are implemented in the first device tier 110. Thus, each of the launch and capture circuits 210 comprise active devices (transistors) comprised in the first set of active devices 114 of the first active device layer 112. The active devices of the launch and capture circuits 210 are interconnected by the first frontside interconnect structure 116. Meanwhile, the processing segments / circuits 220 are implemented in the second device tier 120. Thus, each of the processing circuits 220 comprise active devices (transistors) comprised in the second set of active devices 124 of the second active device layer 122. The active devices of the processing circuits 220 are interconnected by the second frontside interconnect structure 126.

As shown in Fig. 2, the IC device 100 further comprises a clock distribution network 230. The clock distribution network 230 is implemented in the first device tier 110. The clock distribution network 230 may for example be implemented as a clock tree (e.g., an H-tree). However, also other topologies are possible, such as a clock mesh or a clock spine. The clock distribution network 230 comprises a set of clock devices, such as clock drivers, clock repeaters, clock gates, clock dividers, clock multiplexers, and/or clock buffers (input/output buffers and balancing buffers). In Fig. 2, the clock devices are exemplified by clock buffers 232. Each of the clock devices 232 in the first device tier 110 comprises active devices (transistors) comprised in the first set of active devices 114 of the first active device layer 112. The active devices of the clock devices are interconnected by the first frontside interconnect structure 116. The clock distribution network 230 further comprises a plurality of clock signal routing interconnects 234 interconnecting the clock devices, e.g., the clock buffers 232. The clock signal routing interconnects 234 may be realized using a combination of routing layers and via layers of the first frontside interconnect structure 126.

The clock distribution network 230 is configured to distribute clock signals CLK to each clocked circuit of the IC device 100. Thus, the clock distribution network 230 is as shown connected to the clock inputs C of the launch and capture circuits 210. The clock distribution network 230 may further be connected to any clocked circuits in the second device tier 120, if any. In this case, the clock signals may be routed vertically from the first device tier 110 to the second device tier 120 via inter-tier connections in the first and second backside interconnect structures 118, 128. Additionally, it may in this case be beneficial to implement some clock devices (e.g., clock buffers, clock gates, etc.) of the clock distribution network 230 also in the second device tier 120. However, in implementations wherein the second device tier 120 is a clock-less device tier, it is contemplated that the clock distribution network 230, including each of the clock devices, may be implemented exclusively in the first device tier 110.

Still with reference to Fig. 2, the clock distribution network 224 may be co-integrated with a power distribution network (PDN) 240 in the first frontside interconnect structure 116. The PDN 240 is in Fig. 2 indicated in a highly schematic manner, but may, as would be understood by the skilled person, comprise a plurality of power rails (e.g., VDD and VSS) in the frontside interconnect structure 116, and be configured to supply power to the data processing circuit 100 and the clock distribution network 230.

The power distribution network 240 may further be connected to a local power distribution network 242 of the second device tier 120, comprised at least in part in the second backside interconnect structure 128, and optionally also in the second frontside interconnect structure 126. Power may be vertically routed from the power rails of the power distribution network 240 in the first device tier 110 to the local power distribution network 242 via inter-tier connections in the first and second backside interconnect structures 118, 128.

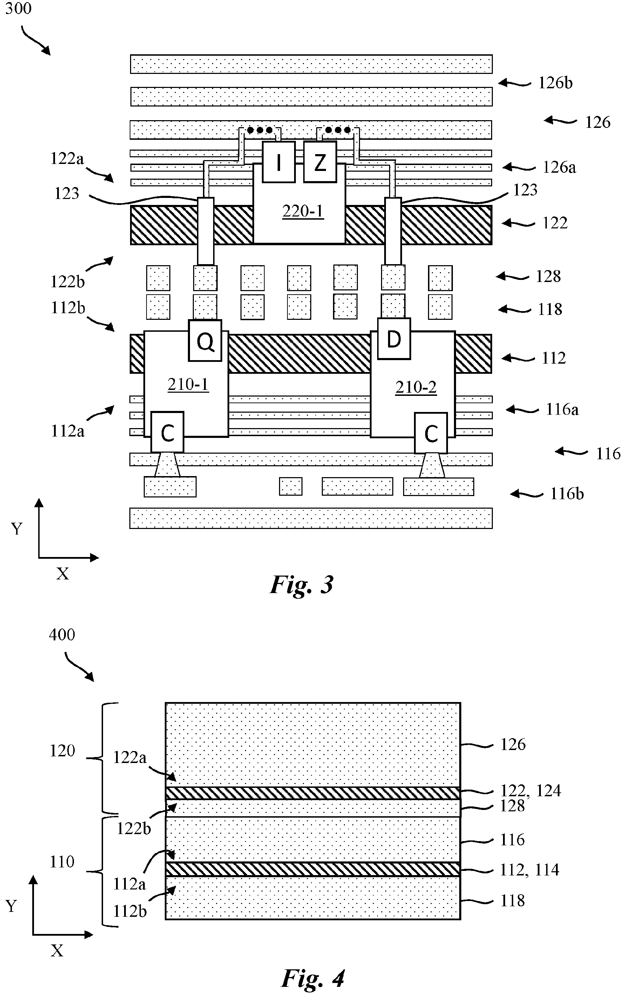

Fig. 3 schematically shows in greater detail a cross-section of a portion of the 3D IC device of Fig. 1, depicting an example implementation of the launch and capture circuits 210-1, 210-2 and a processing stage / circuit 120. For conciseness and ease of explanation, Fig. 1-3 use like reference signs to indicate like or corresponding features. In Fig. 3, terminals "I" and "Z" denote the data input and data output, respectively, of the processing circuit 220-1. Reference signs 123 represent TSVs.

As further shown in Fig. 3, the first frontside interconnect structure 116 may comprise a lower portion 116a (e.g., that may be denoted "Mx") of smaller pitch / width / spacing interconnects and an upper portion 116b (e.g., that may be denoted "My") of greater (relaxed) pitch / width / spacing interconnects. This applies correspondingly to the second frontside interconnect structure 126 and lower portion 126a and upper portion 126b. The "Mx" layers of the frontside interconnect structures 116, 126 may be suitable for implementing the higher density signal routing interconnects between the respective active devices. The "My" layers of the frontside interconnect structures 116, 126 may be suitable for implementing the power rails and the clock signal routing interconnects 234, for example.

Fig. 4 shows a further implementation of an IC device 400. For conciseness and ease of explanation, Fig. 1 and 4 use like reference signs to indicate like or corresponding features. The IC device 400 generally corresponds to the IC device 100 discussed above, but differing in that the first and second device tiers 110, 120 are arranged front-to-back, instead of back-to-back as in IC device 100. Thus, here a first interconnect structure 116 of the first device tier 110 ("first frontside interconnect structure 116") is arranged at a frontside 112a of the first active device layer 112 wherein the frontside 112a faces the second device tier 120. Further, a second interconnect structure 118 of the first device tier 110 ("first backside interconnect structure 118") is arranged at a backside 112b of the first active device layer 112 facing away from the second device tier 120. The first frontside interconnect structure 116 is bonded to a second backside interconnect structure 128 of the second device tier 120. The allocation of the various circuits of the data processing circuit 200, in particular the launch and capture circuits 210 and the processing circuits 220, discussed above with reference to Fig. 2 is the same in Fig. 4. However, for the IC device 400, it may be beneficial to allocate a majority of the interconnects of the clock distribution network 230 and the PDN 240 in the first backside interconnect structure 118 of the first device tier 110, e.g., to reduce routing congestion in the first frontside interconnect structure 116, and to facilitate individual optimization of the first frontside and backside interconnect structures 116, 118 for signal routing between high density logic, and low resistance power and clock distribution, respectively.

As mentioned above, the IC device 100 (or IC device 400) may in addition to a data processing circuit 200, a clock distribution network 230 and a PDN 240, comprise further circuitry. Fig. 5-6 schematically shows two examples of 3D ICs 500, 600 comprising, in addition to launch and capture circuits 510, 610 (corresponding to launch and capture circuits 210 of Fig. 2) in a first device tier 110, and processing stages / circuits 520, 620 (corresponding to processing circuits 220 of Fig. 2) in a second device tier 120, a further circuit ("further first tier circuit") 530, 630 in the first device tier 110.. In the IC device 500, the dashed box 530 indicates an unallocated / unused portion of the second device tier 120. In the IC device 600, the box 630 represents a second further circuit ("further second tier circuit"). The further first tier circuit 530, 630 may for example be a self-contained circuit block of the respective IC device 500, 600, comprising sequential and/or combinational logic, I/O circuitry, etc. The further first tier circuit 530, 630 may include various combinations of registers, macros, IP blocks and/or non-IP blocks. As one example, the further first tier circuit 530, 630 may be an SRAM circuit, e.g., an SRAM macro. The further second tier circuit 640 may be a sequential and/or combinational logic circuit stacked on top of a sequential and/or combinational logic circuit of the further first tier circuit 630. As another example, the further first tier circuit 630 may comprise SRAM peripheral circuitry and the further second tier circuit 640 may be an SRAM circuit stacked on top of and connected to the SRAM peripheral circuitry of the further first tier circuit 630. With further reference to Fig. 2, the further circuit(s) 530, 630, 640 may be connected to the data inputs D and outputs Q of the capture and launch circuits 210, to supply data to, and receive data from, the processing circuit 200. In the IC device 500, it is further shown that the capture and launch circuits 510 in the first device tier 110 and the processing circuits 520 in the second device tier 120 may have different footprints. For instance, the footprint of the processing circuits 520 in the second device tier 120 may exceed the footprint of the capture and launch circuits 510 in the first device tier 110.

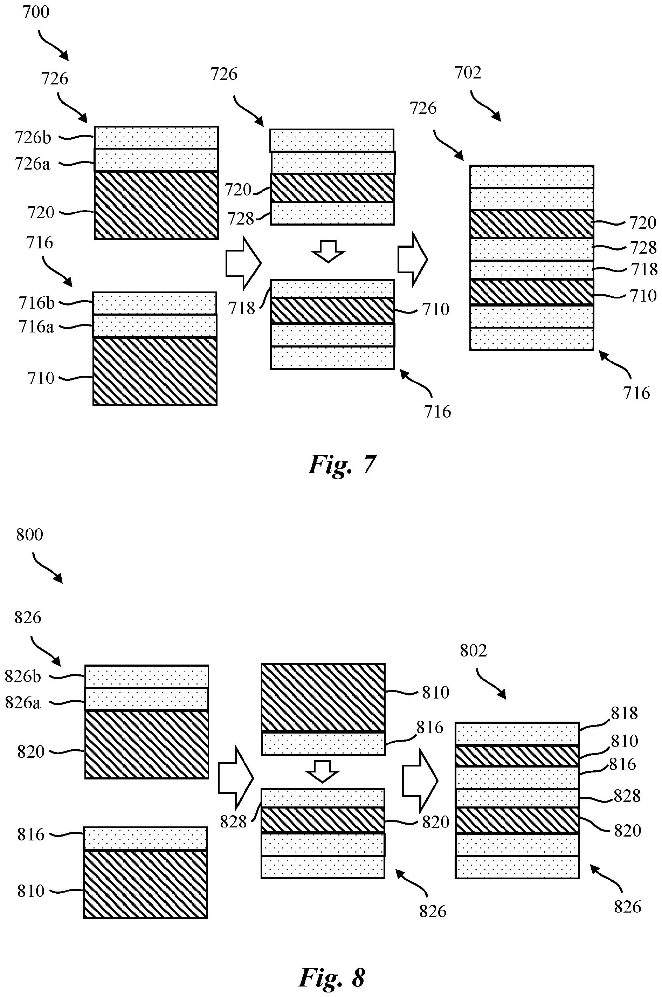

Fig. 7 schematically shows an example of first method for forming a 3D device corresponding to the 3D IC device 100. The method will thus be disclosed with further reference to Fig. 1. The method comprises forming the first device tier 110 on a first wafer 710 and the second device tier 120 on a second wafer 720.

An active device layer 112 (e.g., comprising a FEOL structure) of the first device tier 110 is processed on the first wafer 710, followed by a first frontside interconnect structure 716 (e.g., comprising an Mx portion 716a and an My portion 716b).

Correspondingly, an active device layer 122 (e.g., comprising a FEOL structure) of the second device tier 120 is processed on the second wafer 720, followed by a second frontside interconnect structure 726 (e.g., comprising an Mx portion 726a and an My portion 726b).

Next, backside interconnect structures 718, 728 are processed on the respective backsides of the first and second wafers 710, 720, e.g., subsequent to performing wafer thinning. As may be appreciated, to facilitate wafer thinning and backside processing, each of the first and second wafers 710, 720 may be bonded to respective carrier wafers.

Next the first and second wafers 710, 720 comprising the first and second device tiers 110, 120 are bonded to each other, back-to-back, to form a wafer stack 702, wherein the backside interconnect structures 718, 728 define the bonding interface. After forming the wafer stack 702, any carrier wafers attached to the first and second wafers 710, 720 may be removed.

Fig. 8 schematically shows a second method for forming a 3D device corresponding to the 3D IC device 400. The method will thus be disclosed with further reference to Fig. 4. The method comprises forming the first device tier 110 on a first wafer 810 and the second device tier 120 on a second wafer 820.

An active device layer 112 (e.g., comprising a FEOL structure) of the first device tier 110 is processed on the first wafer 710, followed by a first frontside interconnect structure 816.

Correspondingly, an active device layer 122 (e.g., comprising a FEOL structure) of the second device tier 120 is processed on the second wafer 820, followed by a second frontside interconnect structure 826 (e.g., comprising an Mx portion 826a and an My portion 826b).

Next, a backside interconnect structure 828 is processed on the backside of the second wafer 820, e.g., subsequent to performing wafer thinning. As may be appreciated, to facilitate wafer thinning and backside processing, the second wafer 820 may be bonded to a carrier wafer.

Next the first and second wafers 810, 820 comprising the first and second device tiers 110, 120 are bonded to each other, face-to-back, to form a wafer stack 802, wherein the frontside interconnect structures 816 of the first wafer 810 and the backside interconnect structure 828 of the second wafer 820 define the bonding interface.

Next, wafer thinning may as shown be applied from the backside of the first wafer 810, followed by processing of a backside interconnect structure 818 on the backside of the thinned first wafer 810.

After forming the wafer stack 802, any carrier wafer attached to the second wafers 820 may be removed.

The first and second methods of Fig. 7-8 may each further comprise dicing of the wafer stacks 702, 802, as per se is known in the art. While the illustrated methods involve wafer-to-wafer bonding, it is contemplated that also other fabrication techniques are possible, such as die-to-die bonding or wafer-to-die bonding, wherein, for instance, a second die comprising the second device tier 210 may be bonded to a wafer 710/810 comprising the first device tier 110.

The person skilled in the art realizes that the present invention by no means is limited to the examples described above. On the contrary, many modifications and variations are possible within the scope of the appended claims. For example, in Fig. 2, each launch and capture circuit 210 is implemented by a flip-flop. However, also other implementations of the launch and capture circuits 210 are possible. For example, one or more of the launch and capture circuits 210 may be implemented by latches. A latch represents an asynchronous implementation of a launch and capture circuit and will hence not comprise any clock input. Combinations of flip-flops and latches are also possible. As a further example, while the illustrated embodiments show stacks of two device tiers 110, 120, it is also possible to include one or more further device tiers, e.g. on top of the second device tier 120. For instance, one or more further dies / wafers may be stacked on the second device tier 120 / second wafer 720, 820. Additionally, one or more additional device tiers may be realized using backend transistors arranged in and/or on top of the frontside interconnect structure 128 of the second device tier 120. The term "backend transistors" here refer to BEOL-compatible transistors, i.e., transistors which may be fabricated in a BEOL-compatible process (e.g., in a low / BEOL-compatible thermal budget). For instance, the backend transistors may be thin-film transistors (TFTs) such as carbon nanotube (CNT) field-effect transistors (FETs), 2D channel FETs, oxide-semiconductor FETs.

## Claims

1. A 3D integrated circuit, IC, (100) comprising:
a stack of device tiers comprising a first and a second device tier (110, 120);
a data processing circuit (200) comprising a set of launch and capture circuits (210), and a set of processing stages (220),
wherein each processing circuit (220-1) is connected between a launch circuit and a capture circuit (210-1, 210-2),
wherein the data processing circuit (200) is partitioned between the first and second device tiers (110, 120) such that the set of launch and capture circuits (210) is arranged in the first device tier (110) and the set of processing stages (220) is arranged in the second device tier (120).

2. The 3D IC according to claim 1, wherein each processing circuit (220) is connected to its associated launch and capture circuits (210) by a set of inter-tier interconnects (102, 302).

3. The 3D IC according to any one of the preceding claims, wherein each processing stage (220-1) comprises at least one output combinational logic cell (326) configured to supply output data to its associated capture circuit (210-2), and at least one input combinational logic cell (322) configured to receive input data from its associated launch circuit (210-1).

4. The 3D IC according to claim 3, wherein each processing stage (220) further comprises at least one intermediate logic cell (324) connected between the at least one input and output combinational logic cells.

5. The 3D IC according to any one of the preceding claims, wherein each launch or capture circuit (210) is a latch or a flip flop.

6. The 3D IC according to any one of the preceding claims, further comprising a clock distribution network (230) connected to a set of clock inputs of the launch and capture circuits (210), wherein the clock distribution network (230) at least in part is comprised in the first device tier (110).

7. The 3D IC (100; 400) according to claim 6, wherein the first device tier (110) comprises a first active device layer (112) and a first interconnect structure (118; 116) arranged at a side (112b; 112a) of the first active device layer (112) facing away from the second device tier (120), and wherein the clock distribution network (230) is comprised in first active device layer (112) and the first interconnect structure (118; 116).

8. The 3D IC (100; 400) according to claim 7, wherein the first interconnect structure (118; 116) further comprises a power distribution network (240) connected to the data processing circuit (200) in the first and second device tiers (110, 120).

9. The 3D IC (100; 400) according to any one of claims 7-8, wherein the second device tier (120) comprises a second active device layer (122), a second frontside interconnect structure (126) and a second backside interconnect structure (128) arranged at a frontside (122a) and a backside (122b), respectively, of the second active device layer (122), wherein the second frontside interconnect structure (126) is configured to interconnect active devices (124) of the set of processing stages (220), and wherein the backside of the second active device layer tier (122) faces the first device tier (110).

10. The 3D IC according to claim 9, when dependent on claim 8, wherein the power distribution network (240) of the first interconnect structure (118) is connected to a local power distribution network (242) of the second device tier (120) comprised at least in part in the second backside interconnect structure (128), and optionally also in the second frontside interconnect structure (126).

11. The 3D IC according to any one of the preceding claims, wherein the data processing circuit (200) has a first footprint in the first device tier (110), and a second footprint in the second device tier (120) overlapping the first footprint, and wherein, within the second footprint, the second device tier is clock-less.

12. A method for forming a 3D integrated circuit, IC, (100),
the 3D IC (100) comprising:
a stack of device tiers comprising a first and a second device tier (110, 120);
a data processing circuit (200) comprising a set of launch circuits and capture circuits (210), and a set of processing stages (220),
wherein each processing stage (220-1) is connected between a launch circuit and a capture circuit (210-1, 210-2),
wherein the data processing circuit (200) is partitioned between the first and second device tiers (110, 120) such that the set of launch and capture circuits (210) is arranged in the first device tier (110) and the set of processing stages (220) is arranged in the second device tier (120), and
the method comprising:
forming the first device tier (110) on a first wafer (710, 810) and the second device tier (120) on a second wafer (720, 820); and
forming a wafer stack (702, 802) of the first and second wafers (710, 720; 810, 820).

13. The method according to claim 12,
wherein the first and second wafers (810, 820) each have a frontside and a backside,
wherein forming the first device tier (110) comprises forming active devices of the launch and capture circuits (220) on the frontside of the first wafer (810) and a first frontside interconnect structure (816) on the frontside of the first wafer (810);
wherein forming the second device tier (120) comprises forming active devices of the processing stages (210) on the frontside of the second wafer (820) and a second frontside interconnect structure (826) on the frontside of the second wafer (820);
wherein the first and second wafers (810, 820) are bonded with the first frontside interconnect structure (816) facing the backside of the second wafer (820).

14. The method according to claim 13, wherein forming the second device tier (120) further comprises forming a second backside interconnect structure (828) on the backside of the second wafer (820), and wherein bonding the first and second wafers (810, 820) comprises bonding the first frontside interconnect structure (816) to the second backside interconnect structure (828).

15. The method according to claim 12,
wherein the first and second wafers (710, 720) each have a frontside and a backside,
wherein forming the first device tier (110) comprises forming active devices of the launch and capture circuits (220) on the frontside of the first wafer (710) and a first frontside interconnect structure (716) on the frontside of the first wafer (710);
wherein forming the second device tier (120) comprises forming active devices of the processing stages (210) on the frontside of the second wafer (720) and a second frontside interconnect structure (726) on the frontside of the second wafer (820);
wherein the first and second wafers (810, 820) are bonded with the backside of the first wafer (710) facing the backside of the second wafer (720).
